# EUROPEAN PATENT APPLICATION

(11) **EP 4 693 398 A1**
(43) Date of publication of application: **11.02.2026**
(21) Application number: 25193836.1
(22) Date of filing: 04.08.2025
(51) Int. Cl.: H01L 23/495, H01L 23/31, H01L 21/48, H01L 21/56, H01L 23/48, H01L 23/433

(54) **INTEGRATED CIRCUIT PACKAGE WITH LEADFRAME HAVING CENTRAL OPENING FILLED WITH A DROP-IN DIE PAD**

(30) Priority: 06.08.2024 US 202463679896 P; 31.07.2025 US 202519286869
(71) Applicant: STMicroelectronics International N.V., 1228 Plan-les-Ouates, Geneva (CH)
(72) Inventor: TALLEDO, Jefferson Sismundo, 4027 CALAMBA (PH)
(74) Representative: Casalonga

(57) **Abstract**

An integrated circuit package includes a leadframe with leads delimiting a center cavity. The leads of the leadframe have upper surfaces with a surface texture or finish having a first surface roughness. A drop-in die pad is installed within the center cavity. The drop-in die pad has an upper surface with a surface texture or finish having a second surface roughness that is rougher than the first surface roughness. An integrated circuit die is mounted to the upper surface of the drop-in die pad and electrical connections are formed between bonding pads of the integrated circuit die and the leads of the leadframe. An encapsulation body encapsulates the leadframe, drop-in die pad and electrical connections.

## Description

### CROSS-REFERENCE TO RELATED APPLICATIONS

This application claims priority to United States Provisional Application for Patent No. 63/679,896, filed August 6, 2024, the contents of which are incorporated herein by reference.

### TECHNICAL FIELD

The present invention generally relates to integrated circuit packaging and, more particularly, to a package utilizing a leadframe including a plurality of leads around a central opening filled with a drop-in die to which an integrated circuit chip is mounted.

### BACKGROUND

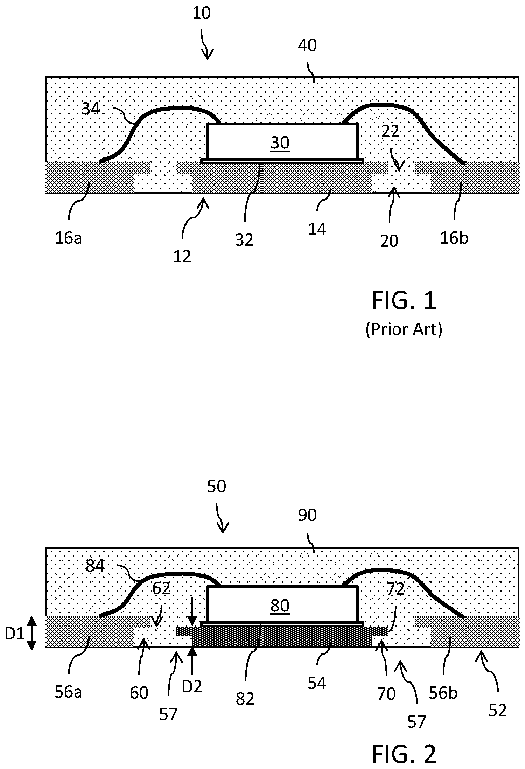

Reference is made to Figure 1 which shows a cross-sectional view of a conventional quad flat no-leads (QFN) type integrated circuit package 10. An etched leadframe 12 of the package 10 includes a die pad 14 and a plurality of leads 16. The plurality of leads 16 are arranged adjacent to one or more side edges of the die pad 14. In an embodiment as illustrated, the die pad 14 is positioned between a row of leads 16a adjacent a first side edge of the die pad 14 and a row of leads 16b adjacent a second side edge of the die pad opposed from the first side edge. In an embodiment, a row of leads 16 is provided adjacent to each of the four side edges of the die pad 14.

Each lead 16 is separated from the die pad 14 by a space defined by a half-etched opening 20 at the bottom of the leadframe and a through opening 22 at the top of the leadframe. Similar openings 20, 22 are provided between adjacent leads 16 in each row of leads.

The leadframe 12 may comprise a pre-plated leadframe (PPF) where surfaces of the leadframe (made, for example, of copper) have been plated with a desired conductive material (such as, for example, silver or a NiPdAu alloy). In this PPF leadframe arrangement, a sheet of metal from which the leadframe 12 is fabricated is shaped (for example, by cutting, stamping and/or etching) to define the die pad 14 and the leads 16 which are physically connected to each other using tie bar and/or framing structures. These tie bar and/or framing structures are subsequently cut during the conventional package manufacturing process, for example following encapsulation, when individual packages are singulated.

An integrated circuit die 30 is mounted to an upper surface of the die pad 14 using a suitable mounting material layer 32. As an example, a die attach film (DAF) may be used to mount the die 30 to the die pad. Bonding pads of the integrated circuit die 30 are electrically connected to the leads 16 using suitable electrical connection elements. As an example, bonding wires 34 may be used to make the electrical connections. Alternatively, or additionally, wire clips or ribbons may be used for electrically connecting the bonding pads to the leads.

The leadframe 12, mounted integrated circuit die 30, and bonding wires 34 are encapsulated within an encapsulating insulating body 40. The body 40 may, for example, be made of a resin material. The encapsulation process may, for example, utilize a molding operation where the leadframe 12, mounted integrated circuit die 30, and bonding wires 34 are retained within the cavity of a mold and the resin material is injected to the cavity and cured.

It will be noted that the bottom surfaces of the die pad 14 and leads 16, as well as the side surfaces of the leads 16, are exposed from the encapsulating insulating body 40 and are thus made available when solder mounting the package 10 to a printed circuit board. These exposed surfaces may be plated by a layer of material (not explicitly shown, for example made of tin or an alloy including tin) that enhances the solderability of the package.

Larger QFN packages, for example those which require a large number of leads and/or mount a larger integrated circuit die 30 and/or support multiple integrated circuit dies 30, suffer from concerns with delamination of the integrated circuit die(s) 30 from the die pad 14. To address this concern, the PPF leadframe 12 may be provided with a roughened surface texture or finish. However, this roughened surface texture or finish for the PPF leadframe can contribute to instability for the non-stick on lead (NSOL) wirebond used in electrically connecting the bonding pads of the integrated circuit die 30 to the leads 16.

There is accordingly a need in the art for an improved integrated circuit package addressing the foregoing problems of the prior art.

### SUMMARY

In an embodiment, an integrated circuit package comprises: a leadframe including a plurality of leads delimiting a center cavity, wherein said leads of the leadframe have an upper surface with a surface texture or finish having a first surface roughness; a drop-in die pad is located within the center cavity, wherein the drop-in die pad has an upper surface with a surface texture or finish having a second surface roughness that is rougher than the first surface roughness; an integrated circuit die mounted to the upper surface of the drop-in die pad; electrical connections between bonding pads of the integrated circuit die and the leads of the leadframe; and an encapsulation body which encapsulates the leadframe, drop-in die pad and electrical connections.

In an embodiment, a method comprises: providing a leadframe including a plurality of leads delimiting a center cavity; wherein said leads of the leadframe have an upper surface with a surface texture or finish having a first surface roughness; providing a drop-in die pad; wherein said drop-in die pad has an upper surface with a surface texture or finish having a second surface roughness that is rougher than the first surface roughness; installing the drop-in die pad at a location within the center cavity of the leadframe; mounting an integrated circuit die to the upper surface of the drop-in die pad; electrically connecting bonding pads of the integrated circuit die to the leads of the leadframe; and encapsulating the leadframe, drop-in die pad and electrical connections within an encapsulating body.

### BRIEF DESCRIPTION OF THE DRAWINGS

For a better understanding of the embodiments, reference will now be made by way of example only to the accompanying figures in which:
Figure 1 shows a cross-sectional view of a conventional quad flat no-leads (QFN) type integrated circuit package;
Figure 2 shows a cross-sectional view of a delamination resistant quad flat no-leads (QFN) type integrated circuit package; and
Figures 3A-3I show steps in a process for manufacturing the package of Figure 2.

### DETAILED DESCRIPTION

Reference is now made to Figure 2 which shows a cross-sectional view of a delamination resistant quad flat no-leads (QFN) type integrated circuit package 50. An etched leadframe 52 of the package 10 includes a plurality of leads 56 which are arranged to delimit a center cavity (or opening) 57 having a four-sided polygonal, for example, square or rectangular, shaped area. The plurality of leads 16 are arranged adjacent to one or more sides of the center cavity 57. In an embodiment as illustrated, there is a row of leads 56a adjacent a first side of the cavity 57 and a row of leads 56b adjacent a second side of the cavity 57 opposed from the first side. In an embodiment, a row of leads 56 is provided adjacent to each of the four sides of the cavity 57, or where the row of leads 56 is provided adjacent to one side of the cavity 57.

The cavity 57 is defined in the leadframe 52 by a half-etched opening 60 at the bottom of the leadframe and a through opening 62 at the top of the leadframe. Similar openings 60, 62 are provided between adjacent leads 56 in each row of leads.

The leadframe 52 may comprise a pre-plated leadframe (PPF) where surfaces of the leadframe have been plated with a desired conductive material (such as, for example, silver or a NiPdAu alloy). However, this leadframe 52 does not include a die pad (compare to die pad 14 of leadframe 12 in Figure 1 which is manufactured with the die pad and leads physically connected by tie bar and/or frame structures), and the cavity 57 is provided where that die pad would otherwise have been located. Thus, the surfaces of the leads 56 of the leadframe 52 will have the plating. In an embodiment, the surfaces of the leads 56 of the leadframe 52 have a surface texture or finish having a first surface roughness. The leadframe 52 has a thickness D1 which is measured across the full thickness of the leads (as indicated by the double-ended arrow) from an uppermost lead surface to a lowermost lead surface.

The package 50 further includes a drop-in die pad 54. The drop-in die pad 54 is positioned within the cavity 57, for example between opposed rows of leads 56 for the leadframe 52. The drop-in die pad 54 is accordingly positioned between a row of leads 56a adjacent a first side edge of the drop-in die pad 54 and a row of leads 56b adjacent a second side edge of the drop-in die pad opposed from the first side edge. In an embodiment, a row of leads 56 is provided adjacent to each of the four side edges of the drop-in die pad 54.

The sides of the drop-in die pad 54 are defined by a half-etched portion 70 at the bottom of the drop-in die pad 54 and a perimeter edge 72 at the top of the drop-in die pad 54.

The drop-in die pad 54 may be pre-plated where surfaces of the drop-in die pad have been plated with a desired conductive material (such as, for example, silver or a NiPdAu alloy). In an embodiment, the upper surface of the drop-in die pad 54 has a surface texture or finish having a second surface roughness which is rougher than the first surface roughness. The leadframe 52 has a thickness D2 which is measured across the full thickness of the drop-in die pad (as indicated by the arrows) from an uppermost pad surface to a lowermost pad surface. The thickness D2 is less than the thickness D1.

For example, the first surface roughness comprises a roughness maximum height less than Ry = 1µm, while the second surface roughness has a roughness maximum height greater than Ry = 1µm. Alternatively, the second surface roughness may be characterized by an S-ratio in a range of 1.15 to 1.55, for example about 1.35, with the first surface roughness characterized by an S-ratio less than 1.15. Maintaining the surface roughness of the leadframe within the foregoing specification ensures that wirebonding to the leads is not a concern. Maintaining the surface roughness of the drop-in die pad within the foregoing specification ensures a good die pad interface adhesion to inhibit against, if not prevent, delamination.

To achieve the second surface roughness distinct from and greater than the first surface roughness, the surface of the metal (for example, copper) material of the drop-in die pad 54 may be roughened prior to plating with the NiPdAu alloy, while the surface of the metal (for example, copper) material of the leads 56b of the leadframe 52 is not similarly treated before plating with the NiPdAu alloy.

The drop-in die pad 54 with the second surface roughness providing a delamination-resistant surface finish may comprise, for example, a NiPdAu plating over a roughened copper base surface, a base surface with Ag plating, a base surface with brown oxide treatment (BOT), and/or the use of surface features on the drop-in die pad to increase adhesion and anchoring of the die such as the use of die pad surface dimpling, micro-etched surface structures, surface protrusions, and surface openings such as holes, slots or grooves. The surface of the metal (for example, copper) material of the leads 56b of the leadframe 52 would be distinguished because it would not have such a delamination-resistant surface finish.

In an embodiment, the surface texture or finish having the second surface roughness may be provided on the upper (top) surface of the drop-in die pad 54, while the lower (bottom) surface of the drop-in die pad 54 may instead use the surface texture or finish having the first surface roughness.

An integrated circuit die 80 is mounted to an upper surface of the drop-in die pad 54 using a suitable mounting material layer 82. As an example, a die attach film (DAF) may be used to mount the die 80 to the drop-in die pad. The relatively rougher surface texture or finish provided by the plating material at the upper surface of the drop-in die pad 54 supports a reduction in risk of delamination. Bonding pads of the integrated circuit die 80 are electrically connected to the leads 56 using a suitable electrical connection element. As an example, bonding wires 84 may be used to make the electrical connections. Alternatively, or additionally, wire clips or ribbons may be used for electrically connecting the bonding pads to the leads. The relatively smoother surface texture or finish provided by the plating material at the upper surface of the leads 56 supports a reduction in risk of non-stick on lead (NSOL) wirebond instability at wedge-bonded locations.

The leadframe 52 with leads 56, the integrated circuit die 80 mounted to the drop-in die pad 54, and bonding wires 84 are encapsulated within an encapsulating insulating body 90. The body 90 may, for example, be made of a resin material. The encapsulation process may, for example, utilize a molding operation where the leadframe 52 with leads 56, integrated circuit die 80 mounted to the drop-in die pad 54, and bonding wires 84 are retained within the cavity of a mold and the resin material is injected to the cavity and cured.

The configuration of the package 50 in Figure 2 presents a number of advantages over the package 10 in Figure 1: a) reduced risk of die pad delamination because of the relatively rougher surface texture of the surface finish provided at the upper surface of the drop-in die pad 54; b) reduced risk of non-stick on lead (NSOL) wirebond instability relatively smoother surface texture of the surface finish provided by at the upper surface of the leads 56; c) the leadframe 52 with leads 56 can be obtained using standard PPF (i.e., without enhanced surface roughness) at a lower cost; d) the use of a leadframe 52 with cavity 57 supports the selection and customization of the drop-in die pad 54 in terms of die pad surface finish, size and thickness; and e) the drop-in die pad can be selected with the thickness D2 less than the thickness D1 of the leadframe 52 to support a reduction in overall package thickness.

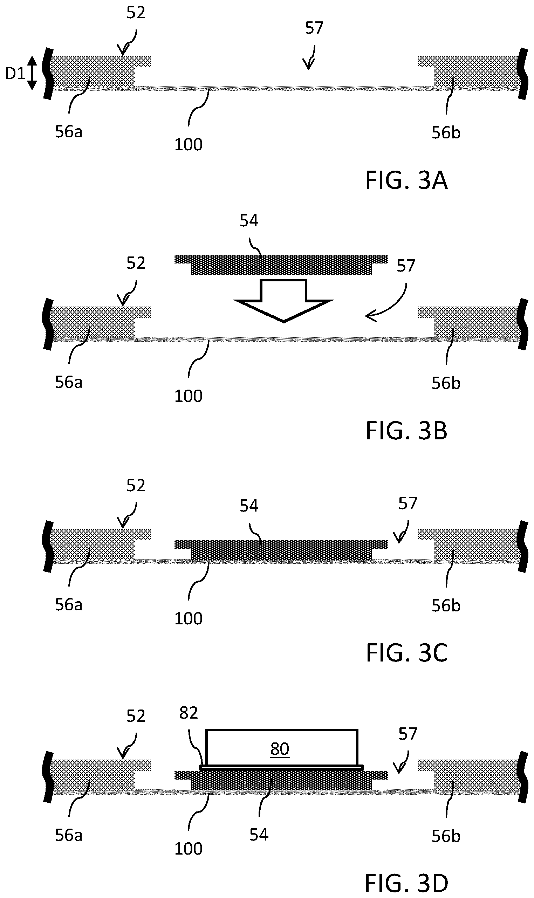

Reference is now made to Figures 3A-3I which show steps in a process for manufacturing the package 50 of Figure 2.

Figure 3A - an etched leadframe 52 which includes a plurality of leads 56 arranged to delimit a center cavity 57 is mounted to a carrier tape 100. The etched leadframe 52 is made of a conductive material (for example, copper) and is preferably of a pre-plated leadframe (PPF) type where at least the upper surfaces of the leadframe have been plated with a desired conductive material (such as, for example, silver or a NiPdAu alloy) and have a surface finish characterized by a first surface roughness (see, surface roughness specification above). The leadframe 52 does not include a die pad positioned between rows of leads 56, with the cavity 57 provided where such a die pad would otherwise have been located. The leadframe 52 has a thickness D1.

Figure 3B - a drop-in die pad 54 is positioned within the center cavity 57. The drop-in die pad 54 is made of a conductive material (for example, copper) and is preferably pre-plated at least at the upper surface of the drop-in die pad with a desired conductive material (such as, for example, silver or a NiPdAu alloy) and has a surface finish characterized by a second surface roughness (see, surface roughness specification above) which is rougher than the first surface roughness. The drop-in die pad (in a preferred embodiment) has a thickness D2 which is less than the thickness D1 of the leadframe 52.

In the context of the present disclosure and the following claims, it will be understood that a "drop-in die pad" means, and is defined as, a structure which provides a die pad for supporting an integrated circuit die but which has not at any point in time been part of the leadframe 52 or connected to any structures of the leadframe 52 by portions of the leadframe (such as a tie bar or frame member). In this regard, those skilled in the art understand that in a conventional leadframe structure, like that shown with leadframe 12 in Figure 1, the sheet of metal from which the leadframe 12 is fabricated is shaped (for example, by cutting, stamping and/or etching) to define the die pad 14 and the leads 16 which are physically connected to each other using tie bar and/or framing structures. These tie bar and/or framing structures are subsequently cut during the conventional package manufacturing process following encapsulation. In the case of the leadframe 52, there is no die pad for IC die mounting present and the leads 56 are physically connected to each other using tie bar and/or framing structures. The sheet of metal from which the leadframe 52 is fabricated is shaped (for example, cutting, stamping and/or etching) to define the leads 16 and provide the cavity 57. The drop-in die pad 54 is a structure that is separately provided independent of the leadframe 52 by shaping (for example, by cutting, stamping and/or etching) a different sheet of metal.

Figure 3C - the drop-in die pad 54 is secured to the carrier tape 100 positioned centrally within the cavity 57 such that rows of leads 56 of the leadframe 52 are located adjacent to, but spaced apart from, correspond sides of the drop-in die pad 54.

Figure 3D - an integrated circuit die 80 is then mounted to an upper surface of the drop-in die pad 54 using a suitable mounting material layer 82 (comprising, for example, a die attach film (DAF)). The surface finish with the second surface roughness provided at the upper surface of the drop-in die pad 54 provides for an enhanced resistance against die pad delamination.

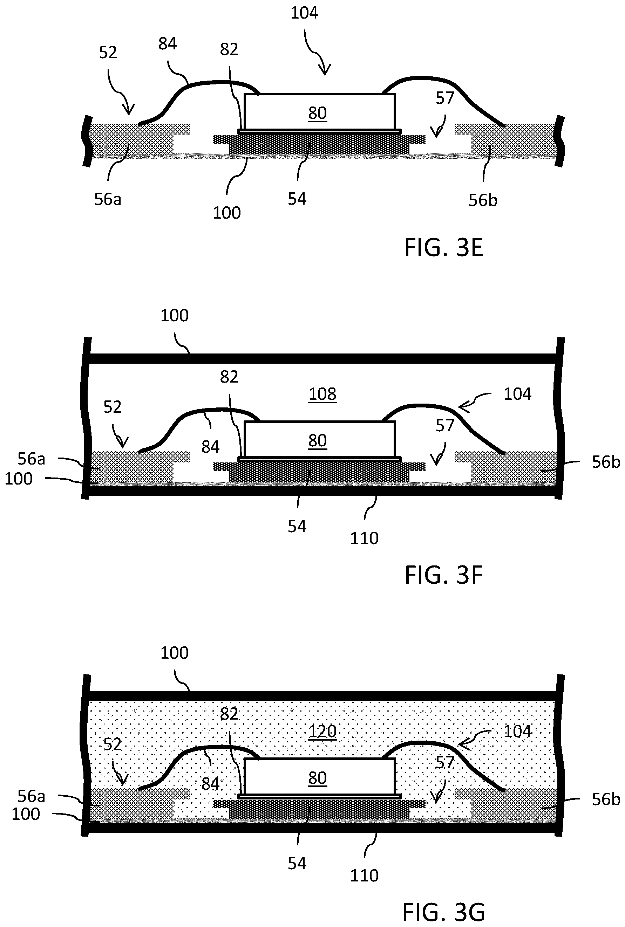

Figure 3E - bonding pads of the integrated circuit die 80 are then electrically connected to the leads 56 using suitable electrical connection elements. As an example, bonding wires 84 may be used to make the electrical connections. The surface finish with the first surface roughness provided at the upper surface of the leads 56 supports a reduction in risk of non-stick on lead (NSOL) wirebond instability when wedge-bonding the bonding wires to the leads.

Figure 3F - the assembly 104 of the leadframe 52 with leads 56, the integrated circuit die 80 mounted to the drop-in die pad 54, and bonding wires 84 is then placed within the cavity 108 of a mold 110.

Figure 3G - an encapsulant material 120 (for example, a resin) is then injected into the cavity 108 of the mold 110 and cured. The half-etched openings 60, 70 at the bottom of the leads 56 of the leadframe 52 and bottom of the drop-in die pad 54 provide support enhancing retention of the encapsulant material 120.

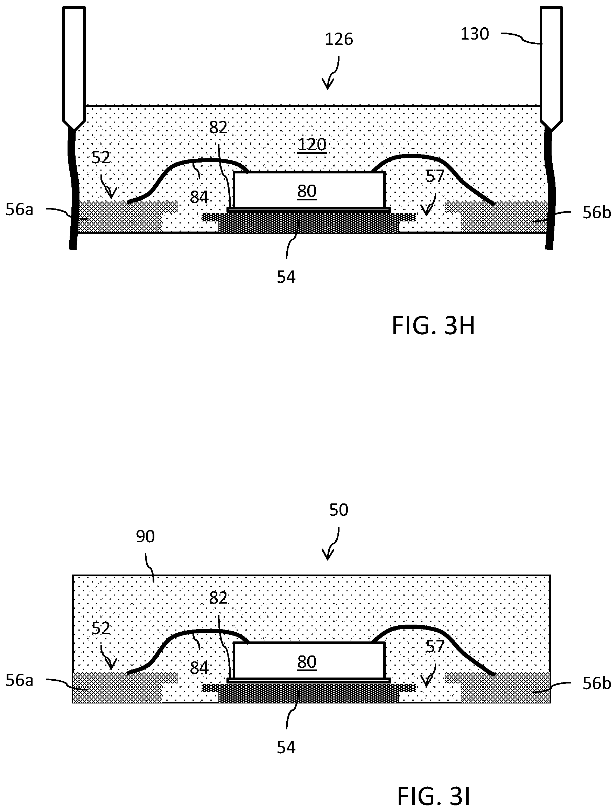

Figure 3H - the assembly 126 of the cured encapsulant material 120 encapsulating the assembly 104 is then removed from the mold 110. The carrier tape 100 may also be removed at this time (or later in the process, as desired).

A singulation process then used with cutting tool 130 (for example, a saw) to cut through the assembly 126 at mid-point locations of the rows of leads 56. This singulation forms the package 50 as shown in Figure 3I where the cured encapsulant material 120 diced in the singulation process forms the encapsulating insulating body 90.

An electroless plating process may then be performed to plate a tin or tin alloy layer on the exposed surfaces of the leadframe 52 and drop-in die pad 54. These exposed surfaces would include, for example, the lower surfaces of the drop-in die pad 54, the lower surfaces of the leads 56 of the leadframe 52, and the sidewalls formed in the leads 56 of the leadframe 52 as a result of the singulation process.

While a preferred implementation of the invention is for a QFN type integrated circuit package, it will be understood that embodiments herein are further applicable to other package types, both with leads and without leads.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. A method, comprising:
providing a leadframe including a plurality of leads delimiting a center cavity;
wherein said leads of the leadframe have an upper surface with a surface texture or finish having a first surface roughness;
providing a drop-in die pad;
wherein said drop-in die pad has an upper surface with a surface texture or finish having a second surface roughness that is rougher than the first surface roughness;
installing the drop-in die pad at a location within the center cavity of the leadframe;
mounting an integrated circuit die to the upper surface of the drop-in die pad;
electrically connecting bonding pads of the integrated circuit die to the leads of the leadframe; and
encapsulating the leadframe, drop-in die pad and electrical connections within an encapsulating body.

2. The method of claim 1, further comprising:
mounting the leadframe including the plurality of leads to a carrier tape; and
wherein installing the drop-in die pad comprises mounting the drop-in die pad to the carrier tape at the location within the center cavity.

3. The method of claim 1, wherein electrically connecting comprises wedge bonding of bonding wires to the leads of the leadframe.

4. The method of claim 1, wherein encapsulating comprises:
placing a first assembly including the leadframe, drop-in die pad and electrical connections within a cavity of a mold; and
injecting encapsulating material into the cavity.

5. The method of claim 4, further comprising:
removing a second assembly including the encapsulated first assembly from the mold; and
singulating the second assembly to form a package.

6. The method of claim 1:
wherein providing the leadframe comprises providing the leads of the leadframe to have a first thickness from an uppermost lead surface to a lowermost lead surface; and
wherein providing the drop-in die pad comprises providing the drop-in die pad to have a second thickness from an uppermost pad surface to a lowermost pad surface;
wherein the first thickness is thicker than the second thickness.

7. The method of claim 1, wherein the first surface roughness comprises a roughness maximum height less than Ry = 1µm and wherein the second surface roughness comprises a roughness maximum height greater than Ry = 1µm.

8. The method of claim 1, wherein the first surface roughness is **characterized by** an S-ratio less than 1.15 and wherein the second surface roughness is **characterized by** an S-ratio in a range of 1.15 to 1.55.

9. The method of claim 1, wherein the drop-in die pad comprises:
a copper base with a roughened surface; and
a NiPdAu plating on the roughened surface;
wherein the roughened surface comprises surface features comprising one or more of: die pad dimples, micro-etched features, protrusions, holes, slots or grooves.

10. An integrated circuit package, comprising:
a leadframe including a plurality of leads delimiting a center cavity, wherein said leads of the leadframe have an upper surface with a surface texture or finish having a first surface roughness;
a drop-in die pad is located within the center cavity, wherein the drop-in die pad has an upper surface with a surface texture or finish having a second surface roughness that is rougher than the first surface roughness;
an integrated circuit die mounted to the upper surface of the drop-in die pad;
electrical connections between bonding pads of the integrated circuit die and the leads of the leadframe; and
an encapsulation body which encapsulates the leadframe, drop-in die pad and electrical connections.

11. The package of claim 10, wherein the leads of the leadframe have a first thickness from an uppermost lead surface to a lowermost lead surface and the drop-in die pad have a second thickness from an uppermost pad surface to a lowermost pad surface, the first thickness being thicker than the second thickness.

12. The package of claim 10, wherein the first surface roughness comprises a roughness maximum height less than Ry = 1µm and wherein the second surface roughness comprises a roughness maximum height greater than Ry = 1µm.

13. The package of claim 10, wherein the first surface roughness is **characterized by** an S-ratio less than 1.15 and wherein the second surface roughness is **characterized by** an S-ratio in a range of 1.15 to 1.55.

14. The package of claim 10, wherein the drop-in die pad comprises:
a copper base with a roughened surface; and
a NiPdAu plating on the roughened surface;
wherein the roughened surface comprises surface features comprising one or more of: die pad dimples, micro-etched features, protrusions, holes, slots or grooves.
